# EUROPÄISCHE PATENTANMELDUNG

(11) **EP 1 182 757 A2**
(43) Veröffentlichungstag der Anmeldung: **27.02.2002**
(21) Anmeldenummer: 01112684.4
(22) Anmeldetag: 25.05.2001
(51) Int. Cl.: H01S 5/40, H01S 5/0683

(54) **Laserdiodenanordnung**

(30) Priorität: 26.07.2000 DE 10036283
(71) Anmelder: ROBERT BOSCH GMBH, 70442 Stuttgart (DE)
(72) Erfinder: Maurer, Dieter, 72793 Pfullingen (DE); Jost, Rolf, 74382 Neckarwestheim (DE); Hildebrand, Ulrich, 70736 Fellbach (DE); Smutny, Berry, 71522 Backnang (DE)

(57) **Zusammenfassung**

Für eine Laserdiodenanordnung insbesondere für einen Pumpmodul zur optischen Kommunikation im Weltall sind die einzelnen Laserdioden (1) auf einem gemeinsamen Substrat (2) angeordnet. Über Leiterstrukturen (5) auf dem Substrat (2) sind die Laserdioden (1) in Serie geschaltet und gemeinsam ansteuerbar.

## Beschreibung

### Stand der Technik

Die Erfindung betrifft eine Laserdiodenanordnung mit mehreren Laserdioden.
Zum Aufbau von Pumpmodulen insbesondere für Nd-YAG-Laser werden Laserdiodenbarren verwendet, in denen die einzelnen Laserdioden elektrisch parallel geschaltet sind.

Aus der US 6,018,602 ist ein optischer Verstärker bekannt mit Laserdioden zur Generierung des Pumplichtes. Die Laserdioden sind in einzelnen Blöcken mitsamt einer jeweiligen Steuerschaltung untergebracht. Die Blöcke selbst sind untereinander in Serie geschaltet.

### Vorteile der Erfindung

Bei der Erfindung sind die Laserdioden auf einem gemeinsamen elektrisch isolierenden Substrat in Serie angeordnet und können gemeinsam angesteuert werden. Dies hat insbesondere den Vorteil, daß ein sehr hoher Wirkungsgrad erzielbar ist. Bei einem optischem Ausfall einer Laserdiode ist die elektrische Serienschaltung nicht unterbrochen und die restlichen betriebsbereiten Laserdioden bleiben bei hohem Wirkungsgrad weiter funktionsfähig.

Bei der erfindungsgemäßen Lösung ist eine gemeinsame Ansteuerung der Laserdiodenanordnung direkt von der Bordnetzspannung eines Satelliten aus möglich oder von dieser auf einfache Weise ableitbar. Die Serienschaltung der Laserdioden stellt niedrige Ströme sicher, die die Stromversorgung von einer entfernten Quelle über relativ dünne Zuleitungen/Kabel erlaubt.

Im Gegensatz zur Lösung gemäß US 6,018,602 sind die Laserdioden auf einem gemeinsamen Substrat angeordnet und erfahren daher einen gemeinsamen Temperaturgang. Dadurch ist eine Temperaturregelung auf sehr einfache Weise möglich.

Wenn gemäß Anspruch 2 das Substrat einen hohen Wärmeleitungskoeffizienten und eine gute Wärmekopplung zu einem Träger aufweist, kann sich die Wellenlängenänderung der Laserdioden infolge der Temperatur kaum nachteilig auswirken.

In der Weiterbildung gemäß Anspruch 3 kann der Träger als Kühlkörper ausgebildet sein oder mit einem solchen in thermischem Kontakt stehen. Dadurch läßt sich der zuvor genannte Effekt noch unterstützen wie auch die Maßnahmen des Anspruchs 9 hierzu beitragen.

Das isolierende Substrat trägt erfindungsgemäß Leiterstrukturen über die die Laserdioden direkt in Serie geschaltet sind und über die auch die gemeinsame Ansteuerung erfolgt. Je nach Ausbildung der Laserdioden können deren Elektroden direkt und/oder über Bonddrähte mit den Leiterstrukturen auf dem Substrat kontaktiert sein.

Auch die Beschaltung der Laserdioden beispielsweise mit weiteren Leiterstrukturen, die auf dem gleichen Träger aufgebracht sind, kann über Bonddrähte erfolgen.

Mangelhafte oder defekte Laserdioden können niederohmig überbrückt werden, ohne daß die Funktion der übrigen Laserdioden nachteilig beeinflußt wird. Vorteilhaft ist es zu diesem Zweck eine oder mehrere Reservedioden vorzusehen, die im Bedarfsfall überbrückbar sind.

Zur Funktionsüberwachung der Laserdiodenanordnung kann eine gemeinsame Monitordiode vorgesehen sein.

Die Anordnung nach der Erfindung eignet sich insbesondere als zuverlässiges Pumpmodul zur optischen Kommunikation im Weltall, das selbst bei Teilausfällen einzelner Laserdioden noch sicher funktioniert.

### Zeichnungen

Anhand der Zeichnungen werden Ausführungsbeispiele der Erfindung geschrieben. Es zeigen
Figur 1 ein Prinzipschaltbild eines herkömmlichen Pumpmoduls mit mehreren Laserdioden,
Figur 2 ein Prinzipschaltbild einer Anordnung nach der Erfindung,
Figur 3 eine Laserdiodenanordnung auf einem gemeinsamen Substrat und
Figur 4 eine Laserdiodenanordnung mit Monitordiode und Temperaturregelung.

### Beschreibung von Ausführungsbeispielen

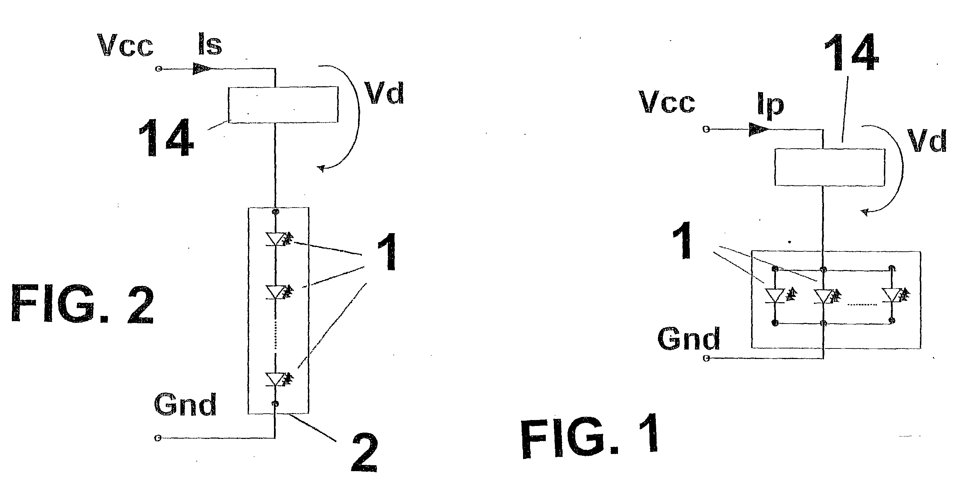

Bei dem in Figur 1 gezeigtem Prinzipschaltbild für ein Pumpmodul mit Laserdioden sind die Laserdioden 1 elektrisch parallel geschaltet. Bei dieser Anordnung ist unter der Annahme einer Versorgungsspannung V_{CC} von 4 Volt, einer Spannungsreserve V_{d} von 2 Volt für die Regelelektronik 14 und einem Strom I_{P} LDPM von 9,6 Ampere ein Wirkungsgrad η von 50% zu erreichen. Bei der erfindungsgemäßen Laserdiodenanordnung, die in der Figur 2 gezeigt ist, und bei der beispielsweise 6 Laserdioden in Serie geschaltet sind, die gemeinsam angesteuert werden, ergibt sich bei einer Versorgungsspannung V_{CC} von 15 Volt, einer Spannungsreserve für die Regelelektronik 14 von V_{d} gleich 2 Volt und einem Strom I_{S} LDPM von 1,6 Ampere ein Wirkungsgrad η von 80%. Diese Spannung von 15 Volt und ein Strom von maximal ca. 2 Ampere kann in einem Satelliten leicht zu Verfügung gestellt werden. Im Gegensatz zur erfindungsgemäße Serienschaltung wird bei einer Parallelschaltung ein Strom von 10 Ampere benötigt. Ein weiterer wichtiger Punkt ist, daß die Serienschaltung im Falle eines Ausfalls einer Laserdiode nicht vollständig ausfällt. Laserdioden haben die Eigenschaft bei einem optischen Ausfall trotzdem elektrisch funktionsfähig zu bleiben. Die Serienschaltung wird durch die ausgefallene Laserdioden demzufolge nicht unterbrochen.

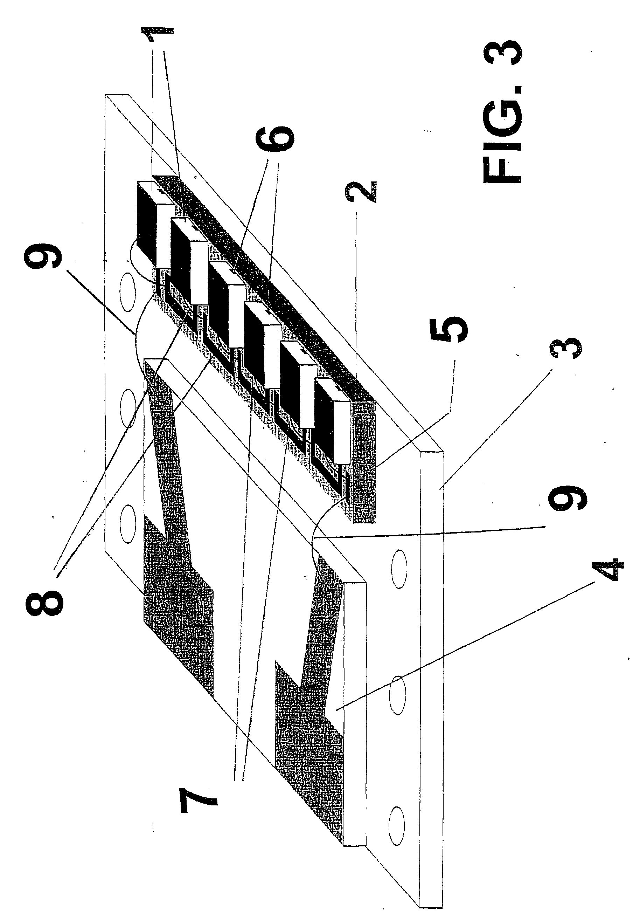

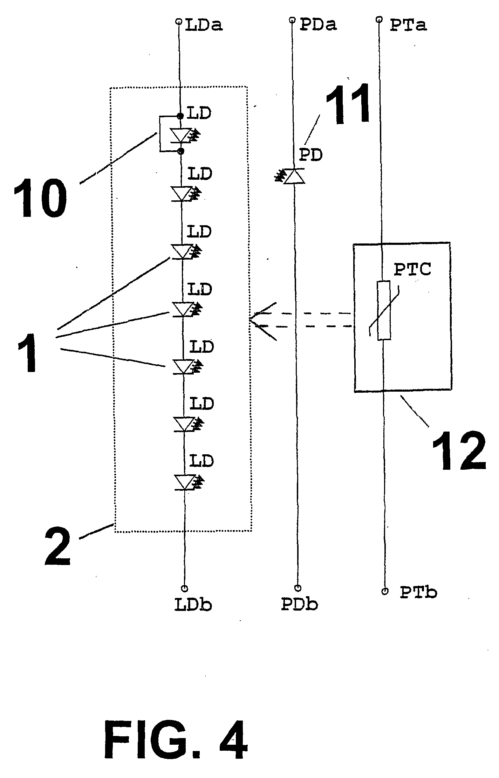

Figur 3 zeigt die erfindungsgemäße Anordnung der in Serie geschalteten Laserdioden 1. Die Laserdioden 1 sind gemeinsam auf einem elektrisch isolierenden Substrat 2 aufgebracht. Dieses Substrat 2 ist mit Leiterstrukturen 5 versehen, über die die einzelnen Laserdioden 1 miteinander in Serie geschaltet sind. Dabei ist jeweils eine erste Elektrode 6 einer Laserdiode 1 direkt auf diese Leiterstrukturen 5 aufgelötet. Die zweite Elektrode 7 ist jeweils über erste Bonddrähte 8 mit den Leiterstrukturen 5 kontaktiert. Das elektrisch isolierende Substrat 2 ist auf einem Träger 3 aufgebracht. Durch Ausgestaltung des Substrats 2 mit einem hohen Wärmeleitungskoeffizienten und einer guten Wärmekopplung (hierzu eignet sich vorzugsweise Diamant) zu dem Träger 3, kann die Verlustwärme der Laserdioden 1 effektiv abgeführt werden, insbesondere wenn der Träger 3 als Kühlkörper ausgebildet ist oder mit einem solchen in thermischem Kontakt steht. Auf dem Träger 3 sind vorteilhaft weitere Substrate mit Leiterstrukturen 4 aufgebracht- in Figur 3 als Pads ausgebildet- über die die Aussenbeschaltung der Laserdioden 1 und/oder die Ansteuerung, beispielsweise über die Regelelektronik 14 erfolgen kann. Die Verbindung der Leiterstrukturen 4 mit den Leiterstrukturen 5 kann über zweite Bonddrähte 9 erfolgen. Durch den Aufbau der Laserdioden auf einem Träger 3 mit Leiterstrukturen 5 wird eine modulartige Anordnung geschaffen, die vorab montiert und abgeglichen werden kann und je nach Einsatzfall einfach über Bonddrähte beschaltet werden kann. Bei der Fertigung kann beispielsweise immer eine oder mehrere Laserdiode/n (Reservediode/n) mehr auf dem Substrat vorgesehen werden als tatsächlich benötigt wird. Eine mangelhafte oder defekte Laserdiode oder eine nicht benötigte Reservediode kann dann einfach über eine Kurzschlußbrücke 10, vergleiche Figur 4 , niederomig überbrückt werden, z.B. nach einem Einlauftest. Dies erhöht die Ausbeute an brauchbaren Modulen in der Fertigung; d.h. durch diese Vorgehensweise können auch noch auf einem gemeinsamen Substrat aufgebrachte Lasermodule benutzt werden bei denen eine oder mehrere Laserdiode/n fertigungsbedingt defekt sind. Fällt eine Laserdiode erst im Betrieb aus, bleiben die restlichen Laserdioden 1, wie zuvor geschildert, trotzdem funktionsfähig.

Wie Figur 4 zeigt, kann die gesamte Laserdiodenanordnung mit nur einer Monitordiode 11 auf ihre Funktion hin überwacht werden. Dieser Monitordiode 11 spricht auf die optische Ausgangsleistung des Pumplasers an. Das Ausgangssignal der Monitordiode 11 kann zur Regelung des Stromes I_{S} durch die Laserdioden 1 herangezogen werden.

Um insbesondere die Wellenlängenänderung der Laserdioden 1 über der Temperatur in einer vorgegebenen Toleranzbereich zu halten, ist eine Temperaturregelung 12 vorgesehen. Als Sensor für die Temperatur ist vorzugsweise ein PTC-Widerstand vorgesehen. In Abhängigkeit des Sensorsignals erfolgt eine entsprechende Kühlung des Substrates 2 bzw. des daran angebrachten Trägers oder Kühlkörpers derart, daß die Temperatur der Laserdiodenanordnung im Betrieb in etwa konstant bleibt.

## Patentansprüche

1. Laserdiodenanordnung mit folgenden Merkmalen:
- mehrere Laserdioden (1) sind auf einem gemeinsamen elektrisch isolierenden Substrat (2) angeordnet,
- es sind Leiterstrukturen (5) auf dem Substrat (2) vorgesehen, über die die Laserdioden (1) miteinander in Serie geschaltet sind und über die eine gemeinsame Ansteuerung der Laserdioden (1) erfolgt.

2. Laserdiodenanordnung nach Anspruch 1, **dadurch gekennzeichnet ,daß** das Substrat (2) einen hohen Wärmeleitungskoeffizienten und eine gute Wärmekopplung zu einem Träger (3) aufweist.

3. Laserdiodenanordnung nach Anspruch 1 oder 2, **dadurch gekennzeichnet daß** der Träger (3) als Kühlkörper ausgebildet ist oder mit einem solchen in thermischem Kontakt steht.

4. Laserdiodenanordnung nach einem der Ansprüche 1 bis 3, **dadurch gekennzeichnet, daß** die Laserdiodenanordnung als Pumpmodul zur optischen Kommunikation insbesondere im Weltall ausgebildet ist.

5. Laserdiodenanordnung nach einem der Ansprüche 1 bis 4, **dadurch gekennzeichnet, daß** erste Elektroden (6) der Laserdioden (1) jeweils direkt mit den Leiterstrukturen (5) kontaktiert sind und zweite Elektroden (7) jeweils über erste Bonddrähte (8).

6. Laserdiodenanordnung nach einem der Ansprüche von 1 bis 5, **dadurch gekennzeichnet, daß** auf dem Träger (3) weitere Leiterstrukturen (4) aufgebracht sind, die mit den Leiterstrukturen (5) auf dem Substrat (2) über zweite Bonddrähte (9) kontaktiert sind.

7. Laserdiodenanordnung nach einem der Ansprüche 1 bis 6, **dadurch gekennzeichnet, daß** Kurzschlußbrücken (10) vorgesehen sind über die mangelhafte oder defekte Laserdioden (1) der Serienschaltung niederohmig überbrückbar sind.

8. Laserdiodenanordung nach einem der Ansprüche 1 bis 7, **dadurch gekennzeichnet, daß** eine oder mehrere Reserve-Laserdioden vorgesehen sind, die insbesondere nach einem Einlauftest niederohmig überbrückbar sind bzw. mangelhafte oder defekte Laserdioden ersetzen können.

9. Laserdiodenanordnung nach einem der Ansprüche 1 bis 8, **dadurch gekennzeichnet, daß** für die mehreren Laserdioden (1) eine gemeinsame Monitordiode (11) zur Funktionsüberwachung vorgesehen ist.

10. Laserdiodenanordnung nach einem der Ansprüche 1 bis 9, **dadurch gekennzeichnet, daß** eine Temperaturregelung (12) vorgesehen ist, um insbesondere die Wellenlängenänderung der Laserdioden (1) über der Temperatur in einem vorgegebenem Toleranzbereich zu halten.

11. Laserdiodenanordnung nach einem der Ansprüche 1 bis 10, **dadurch gekennzeichnet, daß** als Quelle zur Ansteuerung der Laserdioden die Satelliten-Bordnetzspannung benutzt wird oder eine von dieser direkt abgeleitete Spannung.
